# EUROPEAN PATENT APPLICATION

(11) **EP 3 184 430 A1**
(43) Date of publication of application: **28.06.2017**
(21) Application number: 16159553.3
(22) Date of filing: 10.03.2016
(51) Int. Cl.: B64D 13/06, B64D 13/08, B64D 27/24, F25B 21/02, H01L 35/28, H05K 7/00

(54) **ELECTRICAL SYSTEM COOLING IN A MULTI-AXIS PASSENGER-CARRYING AIRCRAFT**

(30) Priority: 25.12.2015 CN 201521110704 U
(71) Applicant: Guanghou Ehang Intelligent Technology Co., Ltd., Guangzhou Guangdong 510663 (CN)
(72) Inventor: Du, Hao, 510663 Guangzhou (CN); Lin, Zuming, 510663 Guangzhou (CN)
(74) Representative: Corradini, Corrado

(57) **Abstract**

A multi-axis passenger-carrying aircraft is provided, comprising: an electrical system; a heat exchange system; a cabin; and an accommodating compartment arranged inside the cabin; wherein the electrical system is arranged inside the accommodating compartment, and wherein the heat exchange system comprises at least an air inlet communicated with the exterior of the cabin, an air outlet communicated with the accommodating compartment, and a cooler with an air inlet end communicated with the air inlet and an air outlet end communicated with the air outlet. In operation, air outside the aircraft may enter the heat exchange system via the air inlet and the cooler via the air inlet end to be cooled by the cooler. The cooled air may be discharged via the air outlet end and then enter the accommodating compartment via the air outlet, providing cool air to the accommodating compartment and dissipating heat from the electrical system. In this way, it allows more stable operation of the electrical system and higher safety factor of the aircraft to ensure its safety.

## Description

### TECHNICAL FIELD

The present disclosure pertains to the field of aircrafts, especially a multi-axis passenger-carrying aircraft.

### BACKGROUND

The applications of multi-axis passenger-carrying aircraft are growing recently because of its good maneuverability and mobility. During a flight, the electrical system powers each electric unit of the aircraft, which generates large amounts of heat, resulting in operational instability and accelerated aging in the electrical system. Additionally, it also incurs risks that compromise the safety of the multi-axis passenger-carrying aircraft.

### SUMMARY

In one aspect of the present disclosure, a multi-axis passenger-carrying aircraft is provided, which is able to cool the electrical system, extend its service life, and ensure the safety of the aircraft.

Therefore, in this aspect of the disclosure, the following technical solutions are disclosed.

A multi-axis passenger-carrying aircraft is provided, comprising: an electrical system; a heat exchange system; a cabin; and an accommodating compartment arranged inside the cabin; wherein the electrical system is arranged inside the accommodating compartment, and wherein the heat exchange system comprises at least an air inlet communicated with the exterior of the cabin, an air outlet communicated with the accommodating compartment, and a cooler with an air inlet end communicated with the air inlet and an air outlet end communicated with the air outlet.

In operation, air outside the aircraft may enter the heat exchange system via the air inlet and the cooler via the air inlet end to be cooled by the cooler. The cooled air may be discharged via the air outlet end and then enter the accommodating compartment via the air outlet, providing cool air to the accommodating compartment and dissipating heat from the electrical system. In this way, it allows more stable operation of the electrical system and higher safety factor of the aircraft to ensure its safety.

The technical solution will be further described below.

In addition to the above, the cooler may be provided with a heat exchange air duct formed by a plurality of semiconductor chilling plates arranged in a circle, with the air inlet end and the air outlet end both communicated with the heat exchange air duct. The cooler may perform heating or cooling with the semiconductor chilling plates, without the need for a compressor or coolant, which is safe and environmental friendly, providing higher safety factor of the aircraft. Meanwhile, it is small in volume and light in weight, allowing lighter total weight of the aircraft. In addition, there is no sliding component and thus high reliability and low noise, further promoting the comfort during the ride.

Furthermore, the heat exchange system may further comprise a circulating pipeline and a water drainage and a water pump provided in the circulating pipeline. The cooler may be provided with a containing cavity for placing the chilling plates and a water inlet and a water outlet communicated with the containing cavity. The circulating pipeline may be communicated with the water inlet at one end and with the water outlet at the other end. The semiconductor chilling plates emit large amounts of heat during operation, which may be dissipated via the water drainage, allowing good heat dissipation effects and longer service life of the semiconductor chilling plates.

Furthermore, two water drainages may be provided symmetrically in the circulating pipeline. The two water drainages provided symmetrically allows better cooling effect.

Furthermore, the multi-axis passenger-carrying aircraft may further comprise a temperature sensor provided within the accommodating compartment and a controller electrically connected to the temperature sensor and electrically connected to the cooler. The temperature sensor detects the temperature within the accommodating compartment and sending the data collected to the controller. The controller regulates the temperature inside the accommodating compartment by manipulating the operation of the cooler, resulting in smart regulation.

Furthermore, the heat exchange system may further comprise an air outlet duct communicated with the air outlet end and the air outlet, the air outlet duct being communicated with a first centrifugal fan. The cooled air is sent to the air outlet by the first centrifugal fan to allow smoother flow of air.

Furthermore, a second centrifugal fan may be provided at the air inlet. The air outside may be sent to the air outlet by the second centrifugal fan to allow smooth air flow.

In comparison with prior art, the disclosure as disclosed in the present application provides the following benefits. In operation, air outside the aircraft may enter the heat exchange system via the air inlet and the cooler via the air inlet end to be cooled by the cooler. The cooled air may be discharged via the air outlet end and then enter the accommodating compartment via the air outlet, providing cool air to the accommodating compartment and dissipating heat from the electrical system. In this way, it allows more stable operation of the electrical system and higher safety factor of the aircraft to ensure its safety.

### BRIEF DESCRIPTION OF DRAWINGS

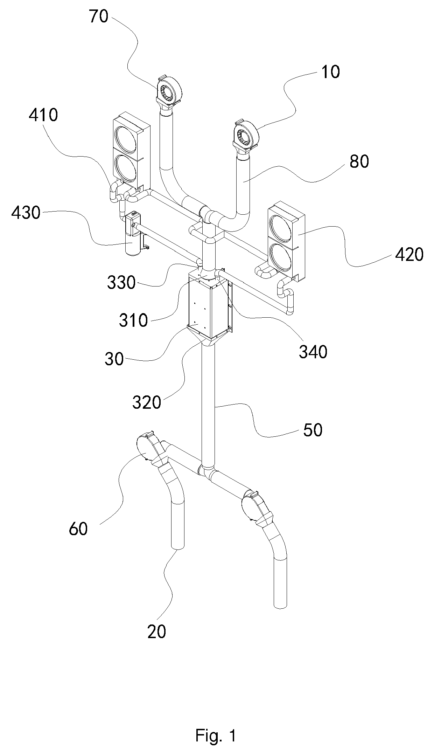

Figure 1 shows a structural schematic of the multi-axis passenger-carrying aircraft according to one embodiment of the present disclosure.

### Description of the referential signs:

10. air inlet, 20. air outlet, 30.cooler, 310. air inlet end, 320. air outlet end, 330. water inlet, 340. water outlet, 410. circulating pipeline, 420. water drainage, 430. water pump, 50. air outlet duct, 60. first centrifugal fan, 70. second centrifugal fan, 80. Air duct.

### DETAILED DESCRIPTION OF PREFERRED EMBODIMENTS

Examples for the purpose of illustrating the embodiments of the present disclosure only will be described in details with reference to the drawings.

As shown in Figure 1, a multi-axis passenger-carrying aircraft is provided, comprising: an electrical system (not labeled in the figure); a heat exchange system; a cabin (not labeled in the figure); an accommodating compartment (not labeled in the figure) arranged inside the cabin; wherein the electrical system is arranged inside the accommodating compartment, and wherein the heat exchange system is at least communicated with an air inlet 10 on the exterior of the cabin, an air outlet 20 communicated with the accommodating compartment, and a cooler 30 with an air inlet end 310 communicated with the air inlet 10 and an air outlet end 320 communicated with the air outlet 20.

In operation, air outside the aircraft may enter the heat exchange system via the air inlet 10 and the cooler 30 via the air inlet end 310 to be cooled by the cooler 30. The cooled air may be discharged via the air outlet end 320 and enter the accommodating compartment via the air outlet 20, providing cool air to the accommodating compartment and dissipating heat from the electrical system. In this way, it allows more stable operation of the electrical system and higher safety factor of the aircraft to ensure its safety.

In this embodiment, the cooler 30 may be provided with a heat exchange air duct (not labeled in the figure) formed by a plurality of semiconductor chilling plates arranged in a circle (not labeled in the figure), with the air inlet end 310 and the air outlet end 320 both communicated with the heat exchange air duct. The cooler 30 may perform heating or cooling with the semiconductor chilling plates, without the need for a compressor or coolant, which is safe and environmental friendly, providing higher safety factor of the aircraft. Meanwhile, it is small in volume and light in weight, allowing lighter total weight of the aircraft. In addition, there is no sliding component and thus high reliability and low noise, further promoting the comfort during the ride. Other heat exchange forms may be adopted by the cooler 30 as desired in practice.

As shown in Figure 1, the heat exchange system may further comprise a circulating pipeline 410 and a water drainage 420 and a water pump 430 provided in the circulating pipeline 410. The cooler 30 may be provided with a containing cavity (not labeled in the figure) for placing the chilling plates and a water inlet 330 and a water outlet 340 communicated with the containing cavity. The circulating pipeline 410 may be communicated with the water inlet 330 at one end and with the water outlet 340 at the other end. The semiconductor chilling plates emit large amounts of heat during operation, which may be dissipated via the water drainage 420, allowing good heat dissipation effects and longer service life of the semiconductor chilling plates.

In this embodiment, two water drainages 420 may be provided symmetrically in the circulating pipeline 410. The two water drainages 420 provided symmetrically allow better cooling effect. More than one water drainages 420 may be provided as desired in practice.

Furthermore, the multi-axis passenger-carrying aircraft may further comprise a temperature sensor (not labeled in the figure) provided within the accommodating compartment and a controller (not labeled in the figure) electrically connected to the temperature sensor and electrically connected to the cooler 30. The temperature sensor detects the temperature within the accommodating compartment and sending the data collected to the controller. The controller regulates the temperature inside the accommodating compartment by manipulating the operation of the cooler 30, resulting in smart regulation.

As shown in Figure 1, the heat exchange system may further comprise an air outlet duct 50 communicated with the air outlet end 320 and the air outlet 20, the air outlet duct 50 being communicated with a first centrifugal fan 60. The cooled air is sent to the air outlet by the first centrifugal fan 60 to allow smoother flow of air.

In this embodiment, the multi-axis passenger-carrying aircraft is provided with two air inlets 10, and a second centrifugal fan 70 is provided at the air inlet 10.The air outlet duct 50 is communicated with two air outlets 20. The cabin is provided with the second centrifugal fan 70 in the roof, the cooler 30 in the lateral plate, and the accommodating compartment in the floor. The air may be sent to the cooler 30 by the second centrifugal fan 70 via an air duct 80 and then to the accommodating compartment via the air outlet end 320. The second centrifugal fan 70, the cooler 30, and the accommodating compartment may be located anywhere else inside the cabin as desired in practice. The numbers of the air inlet 10 and air outlet 20 may be more than one, as desired in practice.

The technical features in the embodiments above may be implemented in any combination. For the purpose of simplicity, not all combinations are described herein. However, such combination should all be considered within the scope of the present disclosure provide that there is no contradiction.

The detailed embodiments described herein are only for the purpose of illustrating the present disclosure, and are not intended to limit the scope of the present disclosure in any way. It would be understand by a person skilled in the art that various changes and modifications can be made to the embodiments described herein without departing from the scope and spirit of the present disclosure. Such changes and modifications are contemplated by the present disclosure, the scope of which should only be defined by the following claims.

## Claims

1. A multi-axis passenger-carrying aircraft, **characterized in that** it comprises:
an electrical system;
a heat exchange system;
a cabin; and
an accommodating compartment arranged inside the cabin;
wherein the electrical system is arranged inside the accommodating compartment, the heat exchange system comprises at least an air inlet communicated with the exterior of the cabin, an air outlet communicated with the accommodating compartment, and a cooler having an air inlet end communicated with the air inlet and an air outlet end communicated with the air outlet.

2. The multi-axis passenger-carrying aircraft according to Claim 1, **characterized in that** the cooler is provided with a heat exchange air duct formed by a plurality of semiconductor chilling plates arranged in a circle, with the air inlet end and the air outlet end both communicated with the heat exchange air duct.

3. The multi-axis passenger-carrying aircraft according to Claim 2, **characterized in that**
the heat exchange system further comprises a circulating pipeline, and a water drainage and a water pump provided in the circulating pipeline;
the cooler is provided with a containing cavity for placing the chilling plates, and a water inlet and a water outlet communicated with the containing cavity; and
the circulating pipeline is communicated with the water inlet at one end and with the water outlet at the other end.

4. The multi-axis passenger-carrying aircraft according to Claim 3, **characterized in that** two water drainages are provided symmetrically in the circulating pipeline.

5. The multi-axis passenger-carrying aircraft according to Claim 1, **characterized in that** it further comprises a temperature sensor provided within the accommodating compartment and a controller electrically connected to the temperature sensor and electrically connected to the cooler.

6. The multi-axis passenger-carrying aircraft according to any of Claims 1-5, **characterized in that** the heat exchange system further comprises an air outlet duct communicated with the air outlet end and the air outlet, the air outlet duct being communicated with a first centrifugal fan.

7. The multi-axis passenger-carrying aircraft according to any of Claims 1-5, **characterized in that** a second centrifugal fan is provided at the air inlet.
